# FASCICULE DE BREVET EUROPEEN

(11) **EP 3 589 091 B1**
(45) Date de publication et mention de la délivrance du brevet: **07.08.2024**
(21) Numéro de dépôt: 19181822.8
(22) Date de dépôt: 21.06.2019
(51) Int. Cl.: H05K 3/34, H05K 1/02, H05K 1/11, H03F 3/00

(54) **DISPOSITIF ÉLECTRONIQUE COMPORTANT UN TRANSISTOR DISCRET MONTÉ SUR UNE CARTE DE CIRCUIT IMPRIMÉ**
ELEKTRONISCHE VORRICHTUNG MIT EINEM DISKRETEN TRANSISTOR, DER AUF EINER KARTE MIT GEDRUCKTEM SCHALTKREIS AUFGEBRACHT IST
ELECTRONIC DEVICE INCLUDING A DISCRETE TRANSISTOR MOUNTED ON A PRINTED CIRCUIT BOARD

(30) Priorité: 25.06.2018 FR 1855665
(43) Date de publication de la demande: 01.01.2020
(73) Titulaire: Commissariat à l'Energie Atomique et aux Energies Alternatives, 75015 Paris (FR); Renault s.a.s, 92100 Boulogne Billancourt (FR)
(72) Inventeur: MAYNARD, Xavier, 38054 GRENOBLE CEDEX 9 (FR); BOUDET, Thierry, 38054 GRENOBLE CEDEX 9 (FR); CARCOUET, Sébastien, 38054 GRENOBLE CEDEX 9 (FR); LOUDOT, Serge, 91190 VILLIERS-LE-BACLE (FR)
(74) Mandataire: Cabinet Beaumont

(56) Documents cités:
- US-A1- 2006 113 657
- US-A1- 2007 170 945
- US-A1- 2012 236 516

## Description

### Domaine

La présente demande concerne un dispositif électronique, aussi appelé carte électronique, comportant un ou plusieurs transistors discrets montés sur une carte de circuit imprimé.

### Exposé de l'art antérieur

De nombreux dispositifs électroniques comportant un ou plusieurs transistors discrets montés sur une carte de circuit imprimé ont déjà été proposés. On s'intéresse ici plus particulièrement à des convertisseurs de puissance dans lesquels un ou plusieurs transistors discrets montés sur une carte de circuit imprimé sont commandés en commutation à une fréquence relativement élevée, dite fréquence de découpage, par exemple une fréquence supérieure à 10 kHz. Dans un tel convertisseur, il est souhaitable que la vitesse de commutation (vitesse d'ouverture et vitesse de fermeture) des transistors soit la plus élevée possible. Ceci permet en effet d'augmenter la fréquence de commutation des transistors, et par conséquent de réduire les dimensions d'un ou plusieurs composants passifs (inductance(s) et/ou condensateur(s)) du convertisseur, tout en maintenant les pertes du convertisseur à un niveau relativement faible. En pratique, la vitesse de commutation des transistors est toutefois limitée, en raison notamment des inductances parasites des éléments conducteurs de connexion reliant le transistor à un circuit de contrôle du transistor.

US2012236516 concerne un composant transistor discret à effet de champ (FET) étant encapsulé dans un boîtier en un matériau isolant laissant accessible des plots de connexion correspondant aux bornes de conduction du transistor source (S), Drain (D) et Grille (G). Ce transistor est connecté à un circuit imprimé de façon à ce que la borne source (S), qui est plus large que les autres bornes, contacte plusieurs plots de connexion de la carte de circuit imprimé. Le circuit imprimé connecte deux plots de connexion soudés à une seule borne du transistor pour aider à l'alignement de celui-ci lors de la soudure grâce à la tension de superficie de la pâte à soudure.

US2006113657 concerne des composants transistors discrets à effet de champ (FET) et un circuit de contrôle connecté aux bornes de commande (G) des transistors et aussi et à leur première borne de conduction (S). La réduction d'inductances parasites de la connexion du transistor se réalise par l'optimisation des distances de connexion entre le circuit de contrôle et les transistors ce qui a pour effet de réduire les résistances et le inductances de connexion.

### Brève description des dessins

Ces caractéristiques et leurs avantages, ainsi que d'autres, seront exposés en détail dans la description suivante de modes de réalisation particuliers faite à titre non limitatif en relation avec les figures jointes parmi lesquelles :
la figure 1A est une vue de dessous schématique d'un exemple d'un transistor discret ;
la figure 1B est une vue de dessus schématique et partielle d'un exemple d'une carte de circuit imprimé destinée à recevoir le transistor de la figure 1A ;
la figure 1C est un schéma électrique équivalent d'un dispositif électronique comportant le transistor de la figure 1A et un circuit de commande de ce transistor, montés sur la carte de circuit imprimé de la figure 1B ;
la figure 2A est une vue de dessous schématique d'un autre exemple d'un transistor discret ;
la figure 2B est une vue de dessus schématique et partielle d'un exemple d'une carte de circuit imprimé destinée à recevoir le transistor de la figure 2A ;
la figure 2C est un schéma électrique équivalent d'un dispositif électronique comportant le transistor de la figure 2A et un circuit de commande de ce transistor, montés sur la carte de circuit imprimé de la figure 2B ;
la figure 3A est une vue de dessous schématique d'un exemple d'un transistor discret d'un dispositif électronique selon un mode de réalisation ;
la figure 3B est une vue de dessus schématique et partielle d'un exemple d'une carte de circuit imprimé d'un dispositif électronique selon un mode de réalisation, destinée à recevoir le transistor de la figure 3A ; et
la figure 3C est un schéma électrique équivalent d'un dispositif électronique selon un mode de réalisation, comportant le transistor de la figure 3A et un circuit de commande de ce transistor, montés sur la carte de circuit imprimé de la figure 3B.

### Description détaillée

De mêmes éléments ont été désignés par de mêmes références dans les différentes figures et, de plus, les diverses figures ne sont pas tracées à l'échelle. Par souci de clarté, seuls les éléments utiles à la compréhension des modes de réalisation décrits ont été représentés et sont détaillés. En particulier, la structure interne des transistors des dispositifs électroniques décrits n'a pas été détaillée, les modes de réalisation décrits étant compatibles avec toutes ou la plupart des structures connues de transistors discrets. De plus, les schémas électriques complets des dispositifs électroniques décrits n'ont pas été détaillés, les modes de réalisation décrits étant compatibles avec tous ou la plupart des dispositifs électroniques comportant des transistors discrets, et en particulier des transistors discrets commandés en commutation, par exemple des convertisseurs à découpage.

On notera que par transistor discret, on entend ici un transistor formé dans et sur une puce semiconductrice indépendante des autres composants du dispositif. Un tel transistor peut en outre comprendre un boîtier d'encapsulation, par exemple en un matériau isolant, laissant accessibles au moins trois plots conducteurs de connexion à un dispositif extérieur, connectés respectivement aux deux bornes de conduction du transistor (la source et le drain dans le cas d'un transistor MOS ou dans le cas d'un transistor HEMT (de l'anglais "High Electron Mobility Transistor" - transistor à haute mobilité d'électrons), par exemple un transistor HEMT au nitrure de gallium (GaN)) et à une borne de commande du transistor (la grille dans le cas d'un transistor MOS ou dans le cas d'un transistor HEMT au GaN). Bien que les modes de réalisation décrits ne se limitent pas à ce cas particulier, on s'intéresse ici plus particulièrement à des transistors de puissance, c'est-à-dire des transistors adaptés à tenir des tensions relativement élevées à l'état ouvert (bloqué), par exemple des tensions supérieures ou égales à 100 V et de préférence supérieures ou égales à 500 V, et/ou à laisser passer des courants relativement élevés à l'état fermé (passant), par exemple des courants supérieurs ou égaux à 1 A et de préférence supérieurs ou égaux à 10 A.

Par ailleurs, on entend ici par carte de circuit imprimé ou PCB (de l'anglais "Printed Circuit Board") un support en forme de plaque permettant de maintenir et de relier électriquement entre eux une pluralité de composants électroniques discrets, dans le but de réaliser un dispositif électronique complexe aussi appelé carte électronique. Une carte de circuit imprimé est par exemple constituée d'un empilement d'une couche support en un matériau isolant, et d'une ou plusieurs couches conductrices, par exemple en cuivre, séparées les unes des autres par un matériau isolant. Les couches conductrices sont localement gravées, par exemple par un procédé chimique, pour définir un ensemble de plots conducteurs de connexion auxquels sont destinés à être soudés ou brasés des plots conducteurs de connexion correspondants des composants du dispositif, et un ensemble de pistes conductrices reliant entre eux les plots de connexion de la carte de circuit imprimé.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence à l'orientation des figures, étant entendu que, en pratique, les dispositifs décrits peuvent être orientés différemment. Sauf précision contraire, les expressions "approximativement", "sensiblement", et "de l'ordre de" signifient à 10 % près, de préférence à 5 % près.

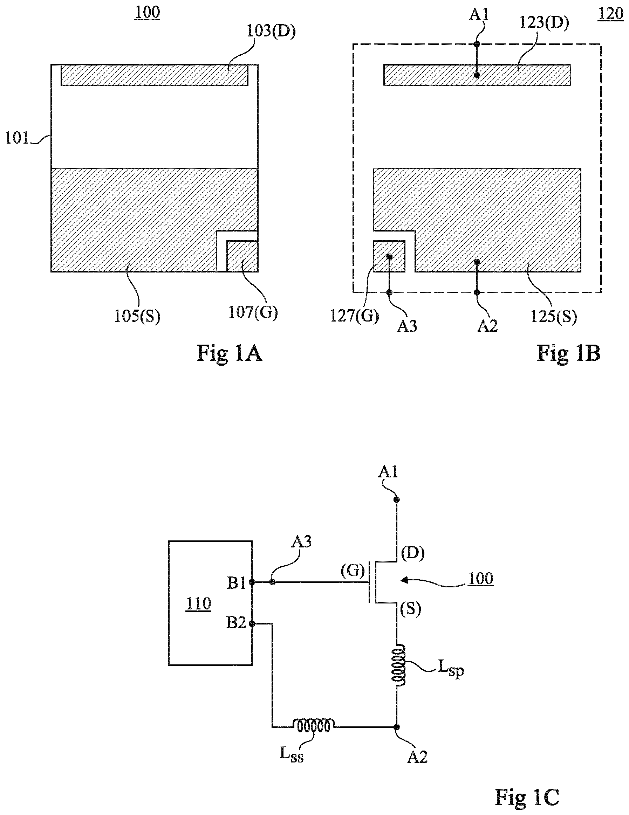

La figure 1A est une vue de dessous schématique d'un exemple d'un transistor discret 100. Le transistor 100 comprend une puce semiconductrice (non visible sur la figure 1A) dans et sur laquelle est formée la partie active du transistor. Dans cet exemple, la puce semiconductrice est encapsulée dans un boîtier 101 en un matériau isolant, par exemple en résine, laissant accessibles uniquement trois plots 103, 105 et 107 de connexion du transistor à un dispositif extérieur. Les plots 103, 105 et 107 sont par exemple en métal, par exemple en cuivre. Dans cet exemple, le transistor 100 est un transistor HEMT au GaN ou un transistor MOS, les plots 103, 105 et 107 étant respectivement connectés, à l'intérieur du boîtier 101, au drain, à la source et à la grille du transistor. Dans cet exemple, le boîtier 101 a une forme générale parallélépipédique, tous les plots de connexion du transistor à un dispositif extérieur étant disposés du côté de la face inférieure du transistor (la face visible sur la figure 1A).

La figure 1B est une vue de dessus schématique et partielle d'un exemple d'une carte de circuit imprimé 120 destinée à recevoir le transistor 100 de la figure 1A. La carte de circuit imprimé 120 comprend, du côté de sa face supérieure, trois plots de connexion 123, 125 et 127, par exemple en métal, par exemple en cuivre, destinés à être connectés respectivement aux trois plots de connexion 103, 105 et 107 du transistor 100. Dans cet exemple, les plots 123, 125 et 127 de la carte de circuit imprimé 120 ont, vus de face, sensiblement la même forme et les mêmes dimensions que, respectivement, les plots 103, 105 et 107 du transistor 100. Dans cet exemple, le transistor 100 et la carte de circuit imprimé 120 sont destinés à être assemblés par montage en surface. Autrement dit, la face inférieure de chacun des plots de connexion 103, 105 et 107 du transistor est fixée et connectée électriquement, par exemple par soudure ou par brasure, à la face supérieure du plot de connexion correspondant 123, respectivement 125, respectivement 127 de la carte de circuit imprimé 120.

La carte de circuit imprimé 120 peut en outre comprendre des pistes conductrices (non détaillées sur la figure 1B), reliant les plots de connexion 123, 125 et 127 à des plots de connexion à d'autres composants discrets du dispositif ou à des bornes de connexion extérieures du dispositif. Par souci de simplification, sur la figure 1B, on a simplement représenté de façon schématique une borne A1 de la carte de circuit imprimé 120, à laquelle est connecté le plot 123 (correspondant au drain du transistor), une borne A2 de la carte de circuit imprimé 120, à laquelle est connecté le plot 125 (correspondant à la source du transistor), et une borne A3 de la carte de circuit imprimé 120, à laquelle est connecté le plot 127 (correspondant à la grille du transistor). En utilisation, le transistor 100 a pour fonction de moduler ou de commuter un courant circulant entre les bornes A1 et A2 du dispositif. Pour cela, le dispositif comprend un circuit (non visible sur la figure 1B) de contrôle du transistor 100, également monté sur la carte de circuit imprimé 120 et connecté entre les bornes A3 et A2 du dispositif. Plus particulièrement, dans le cas d'un transistor HEMT au GaN ou d'un transistor MOS, le circuit de contrôle applique une tension de commande entre la grille (par l'intermédiaire de la borne A3) et la source (par l'intermédiaire de la borne A2) du transistor pour contrôler le courant circulant entre les bornes de conduction (drain et source) du transistor.

La figure 1C est un schéma électrique équivalent d'un dispositif électronique comportant le transistor 100 de la figure 1A et un circuit de contrôle 110 de ce transistor, montés sur la carte de circuit imprimé 120 de la figure 1B. Le circuit de contrôle 110 comprend une première borne B1 connectée à la borne A3 (elle-même connectée à la grille du transistor 100), et une deuxième borne B2 connectée à la borne A2 (elle-même connectée à la source du transistor 100). Sur la figure 1C, on a représenté une première inductance Lₛₚ, reliant la source (S) du transistor 100 à la borne A2, et une deuxième inductance Lₛₛ reliant la borne A2 à la borne B2 du circuit de contrôle 110. L'inductance Lₛₚ correspond à l'inductance parasite de l'ensemble des éléments conducteurs reliant la source (S) du transistor 100 à la borne A2, à savoir le plot de connexion 105 du transistor, le plot de connexion correspondant 125 de la carte de circuit imprimé, et la ou les pistes conductrices reliant le plot 125 à la borne A2. L'inductance Lₛₛ correspond quant à elle à l'inductance parasite de l'ensemble des éléments conducteurs (non détaillés sur les figures) reliant la borne A2 du dispositif à la borne B2 du circuit de commande.

Bien que les inductances parasites Lₛₚ et Lₛₛ soient très faibles, ces dernières peuvent perturber la tension grille-source effectivement vue par le transistor. En particulier, en fonctionnement, l'inductance Lₛₚ est susceptible d'être traversée par des courants importants dans la mesure où elle se situe sur le chemin de puissance principal du transistor. Lors des commutations à l'état ouvert ou à l'état fermé du transistor, une variation rapide du courant circulant dans l'inductance Lₛₚ se produit, ce qui peut générer une tension relativement élevée aux bornes de l'inductance Lₛₚ. A titre d'exemple, pour une commutation d'un courant de 50 A en une période de commutation de 5 ns, la vitesse de variation du courant dans l'inductance Lₛₚ est de 50 kA/ps. En considérant une inductance Lₛₚ de 1 nH (ce qui correspond à une longueur de piste conductrice de l'ordre de 1 mm sur une carte de circuit imprimé), la tension aux bornes de l'inductance Lₛₚ pendant la période de commutation peut atteindre 10 V. Ainsi, la tension de commande effectivement vue par le transistor est fortement influencée par l'inductance parasite Lₛₚ, ce qui peut conduire à des dysfonctionnements, voire à un claquage du transistor.

L'inductance Lₛₛ est quant à elle moins gênante dans la mesure où les courants qui la traversent sont en pratique négligeables par rapport au courant traversant l'inductance Lₛₚ.

Une solution pour limiter les dysfonctionnements évoqués ci-dessus est de limiter la vitesse de commutation du transistor. Comme indiqué ci-dessus, dans un convertisseur à découpage, ceci implique une diminution de la fréquence de découpage et par conséquent une augmentation des dimensions des composants passifs du convertisseur, ainsi qu'une augmentation des pertes de commutation.

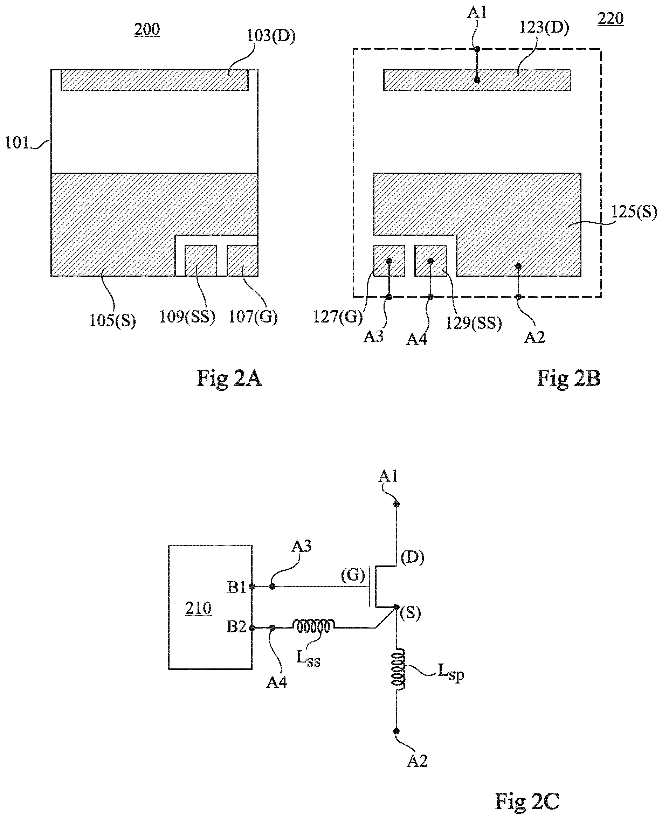

La figure 2A est une vue de dessous schématique d'un autre exemple d'un transistor discret 200. Le transistor 200 comprend les mêmes éléments que le transistor 100 de la figure 1A, agencés sensiblement de la même manière, et comprend en outre un plot supplémentaire 109 de connexion à un dispositif extérieur. Dans l'exemple représenté, le plot 109 est disposé sur la même face du boîtier 101 que les plots 103, 105 et 107, à savoir la face inférieure du boîtier. Le plot 109 est par exemple en le même matériau conducteur que les plots 103, 105 et 107. A l'intérieur du boîtier 101, le plot 109 est connecté à la région de source du transistor. A titre d'exemple, à l'intérieur du boîtier, le plot 109 (SS) est connecté à la même borne de source que le plot 105. Vu de l'extérieur, le plot 109 est toutefois isolé latéralement du plot 105 par le matériau isolant du boîtier 101. Le plot 109 constitue un plot de contrôle de source, destiné à être connecté au circuit de contrôle du transistor, tandis que le plot 105 constitue un plot de source de conduction, destiné à être connecté sur le chemin de puissance du dispositif.

La figure 2B est une vue de dessus schématique et partielle d'un exemple d'une carte de circuit imprimé 220 destinée à recevoir le transistor 200 de la figure 2A. La carte de circuit imprimé 220 comprend, du côté de sa face supérieure, quatre plots de connexion 123, 125, 127 et 129, par exemple en métal, par exemple en cuivre, destinés à être connectés respectivement aux quatre plots de connexion 103, 105, 107 et 109 du transistor 200. Dans cet exemple, les plots 123, 125, 127 et 129 de la carte de circuit imprimé 220 ont, vus de face, sensiblement la même forme et les mêmes dimensions que, respectivement, les plots 103, 105, 107 et 109 du transistor 200. Dans cet exemple, les plots 129 et 125 sont disjoints, c'est-à-dire que, en l'absence du transistor 200 (avant montage du transistor 200 sur la carte de circuit imprimé), les plots 129 et 125 sont électriquement isolés l'un de l'autre.

Dans cet exemple, le transistor 200 et la carte de circuit imprimé 220 sont destinés à être assemblés par montage en surface. Autrement dit, la face inférieure de chacun des plots de connexion 103, 105, 107 et 109 du transistor est fixée et connectée électriquement, par exemple par soudure ou par brasure, à la face supérieure du plot de connexion correspondant 123, respectivement 125, respectivement 127, respectivement 129 de la carte de circuit imprimé 220.

La carte de circuit imprimé 220 peut en outre comprendre des pistes conductrices (non détaillées sur la figure 2B), reliant les plots de connexion 123, 125, 127 et 129 à des plots de connexion à d'autres composants discrets du dispositif ou à des bornes de connexion extérieures du dispositif. Par souci de simplification, sur la figure 2B, on a simplement représenté de façon schématique une borne A1 de la carte de circuit imprimé 220, à laquelle est connecté le plot 123, une borne A2 de la carte de circuit imprimé 220, à laquelle est connecté le plot 125, une borne A3 de la carte de circuit imprimé 220, à laquelle est connecté le plot 127, et une borne A4 de la carte de circuit imprimé 220, à laquelle est connecté le plot 129. En utilisation, le transistor 200 a pour fonction de moduler ou de commuter un courant circulant entre les bornes A1 et A2 du dispositif. Pour cela, le dispositif comprend un circuit (non visible sur la figure 2B) de contrôle du transistor 200, également monté sur la carte de circuit imprimé 220, connecté entre les bornes A3 et A4 du dispositif. Plus particulièrement, dans le cas d'un transistor HEMT au GaN ou d'un transistor MOS, le circuit de contrôle applique une tension de commande entre la grille (par l'intermédiaire de la borne A3) et la source (par l'intermédiaire de la borne A4) du transistor pour contrôler le courant circulant entre les bornes de conduction A1 (drain) et A2 (source) du dispositif.

La figure 2C est un schéma électrique équivalent d'un dispositif électronique comportant le transistor 200 de la figure 2A et un circuit de contrôle 210 de ce transistor, montés sur la carte de circuit imprimé 220 de la figure 2B. Le circuit de contrôle 210 comprend une première borne B1 connectée à la borne A3 (elle-même connectée à la grille du transistor 200), et une deuxième borne B2 connectée à la borne A4 (elle-même connectée à la source du transistor 200). Sur la figure 2C, on a représenté une première inductance Lₛₚ, reliant la source (S) du transistor 200 à la borne A2, et une deuxième inductance Lₛₛ reliant la source (S) du transistor 200 à la borne B2 du circuit de contrôle 210. L'inductance Lₛₚ correspond à l'inductance parasite de l'ensemble des éléments conducteurs reliant la source (S) du transistor 200 à la borne A2, à savoir le plot de connexion 105 du transistor, le plot de connexion correspondant 125 de la carte de circuit imprimé, et la ou les pistes conductrices reliant le plot 125 à la borne A2. L'inductance Lₛₛ correspond quant à elle à l'inductance parasite de l'ensemble des éléments conducteurs reliant la source (S) du transistor 200 à la borne B2, à savoir le plot de connexion 109 du transistor, le plot de connexion correspondant 129 de la carte de circuit imprimé, et la ou les pistes conductrices reliant le plot 129 à la borne A4 (ainsi qu'éventuellement la ou les pistes conductrices reliant la borne A4 à la borne B2, dont l'inductance parasite est considérée comme négligeable dans l'exemple représenté).

Comme l'illustre le schéma de la figure 2C, la prévision, dans le transistor 200, d'un plot de contrôle de source 109 distinct du plot de source de conduction 105, et, sur la carte de circuit imprimé 220, d'un plot de contrôle de source correspondant 129 distinct du plot de source de conduction 125, permet de rendre négligeable l'inductance parasite de connexion de source vue à la fois par le circuit de contrôle 210 et par le chemin de puissance du dispositif.

Dans la configuration des figures 2A, 2B et 2C, l'inductance Lₛₚ est toujours susceptible d'être traversée par des courants importants, ce qui peut, comme expliqué ci-dessous en relation avec la figure 1C, conduire à l'apparition d'une tension relativement élevée à ses bornes lors des commutations du transistor. Toutefois, à la différence de la configuration des figures 1A, 1B et 1C, ceci ne perturbe pas la tension de commande effectivement vue par le transistor, dans la mesure où l'inductance Lₛₚ est en dehors du chemin de connexion entre la borne B2 du circuit de contrôle et la source du transistor.

De même que dans la configuration des figures 1A, 1B et 1C, l'inductance Lₛₛ est quant à elle peu gênante dans la mesure où les courants qui la traversent sont négligeables par rapport au courant traversant l'inductance Lₛₚ.

Ainsi, la configuration des figures 2A, 2B et 2C permet d'appliquer au transistor une vitesse de commutation plus élevée que dans la configuration des figures 1A, 1B et 1C, sans augmenter les risques de dysfonctionnements.

Toutefois, un inconvénient de cette solution est qu'elle nécessite d'utiliser des transistors discrets spécifiques, munis d'un plot de contrôle supplémentaire (le plot 109 dans l'exemple de la figure 2A), qui ne sont pas toujours disponibles dans les catalogues des fabricants de composants semi-conducteurs.

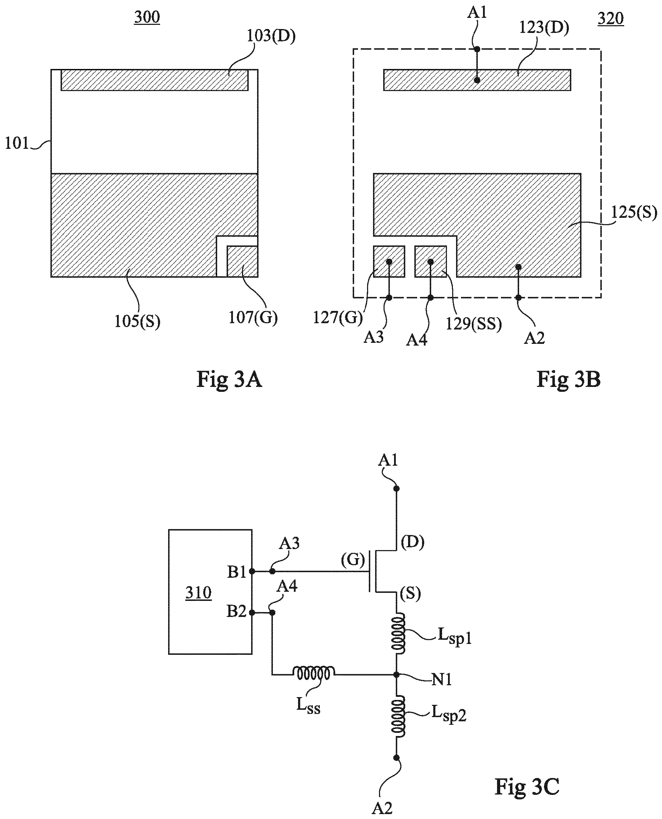

Les figures 3A, 3B et 3C illustrent de façon schématique un exemple d'un mode de réalisation d'un dispositif électronique comportant un transistor discret 300 monté sur une carte de circuit imprimé 320. Les figures 3A et 3B sont respectivement une vue de dessous du transistor 300 et une vue de dessus de la carte de circuit imprimé 320, et la figure 3C est un schéma électrique équivalent du dispositif.

Dans cet exemple, le transistor 300 est identique ou similaire au transistor 100 de la figure 1A. En particulier, dans cet exemple, le transistor 300 comprend un unique plot 105 de connexion à la source (S) du transistor accessible à l'extérieur du boîtier 101.

La carte de circuit imprimé 320 est quant à elle identique ou similaire à la carte de circuit imprimé 220 de la figure 2B. Plus particulièrement, dans cet exemple, la carte de circuit imprimé 320 comprend deux plots de connexion de source 125 et 129 disjoints. Le plot 125 constitue un plot de source de conduction du dispositif, et le plot 129 constitue un plot de contrôle de source du dispositif.

Dans l'exemple des figures 3A, 3B et 3C, les plots 125 et 129 sont destinés, lors du montage du transistor 300, à être tous deux connectés au plot de connexion de source 105 du transistor.

Autrement dit, lors du montage du transistor 300, la face inférieure du plot de connexion de source 105 du transistor 300 est fixée et connectée électriquement, par exemple par soudure ou par brasure, à la fois à la face supérieure du plot 125 et à la face supérieure du plot 129.

De façon similaire à ce qui a été décrit dans l'exemple des figures 2A, 2B et 2C, les plots 125 et 129 sont isolés électriquement l'un de l'autre en l'absence du transistor 300 (avant montage du transistor sur la carte de circuit imprimé).

De préférence, le plot de contrôle de source 129 est voisin du plot de connexion de grille 127 de la carte de circuit imprimé, c'est-à-dire qu'il est séparé latéralement du plot 127 uniquement par le matériau isolant de la carte de circuit imprimé, et non par un autre élément conducteur de la carte de circuit imprimé. A titre d'exemple, en vue de dessus, la distance entre le plot 127 et le plot 129 est inférieure au dixième de la plus grande dimension du transistor 300.

La carte de circuit imprimé 320 peut en outre comprendre des pistes conductrices (non détaillées sur la figure 3B), reliant les plots de connexion 123, 125, 127 et 129 à des plots de connexion à d'autres composants discrets du dispositif ou à des bornes de connexion extérieures du dispositif. Par souci de simplification, sur la figure 3B, on a simplement représenté de façon schématique une borne A1 de la carte de circuit imprimé 320, à laquelle est connecté le plot 123, une borne A2 de la carte de circuit imprimé 320, à laquelle est connecté le plot 125, une borne A3 de la carte de circuit imprimé 320, à laquelle est connecté le plot 127, et une borne A4 de la carte de circuit imprimé 320, à laquelle est connecté le plot 129.

En utilisation, le transistor 300 a pour fonction de moduler ou commuter un courant circulant entre les bornes A1 et A2 du dispositif. Pour cela, le dispositif comprend un circuit (non visible sur la figure 3B) de contrôle du transistor 300, également monté sur la carte de circuit imprimé 320, connecté entre les bornes A3 et A4 du dispositif. Plus particulièrement, dans le cas d'un transistor HEMT au GaN ou d'un transistor MOS, le circuit de contrôle applique une tension de commande entre la grille (par l'intermédiaire de la borne A3) et la source (par l'intermédiaire de la borne A4) du transistor pour contrôler le courant circulant entre les bornes de conduction A1 (drain) et A2 (source) du dispositif.

La figure 3C est un schéma électrique équivalent d'un dispositif électronique comportant le transistor 300 de la figure 3A et un circuit de contrôle 310 de ce transistor, montés sur la carte de circuit imprimé 320 de la figure 3B. Le circuit de contrôle 310 comprend une première borne B1 connectée à la borne A3 (elle-même connectée à la grille du transistor 300), et une deuxième borne B2 connectée à la borne A4 (elle-même connectée à la source du transistor 300). Sur la figure 3C, on a représenté une association en série d'une première inductance Lₛₚ₁ et d'une deuxième inductance Lₛₚ₂, reliant la source (S) du transistor 300 à la borne A2, et une troisième inductance Lₛₛ reliant le point milieu N1 entre les inductances Lₛₚ₁ et Lₛₚ₂ à la borne B2 du circuit de contrôle 310. L'inductance Lₛₚ₁ correspond à l'inductance parasite de l'ensemble des éléments conducteurs reliant la source (S) du transistor 300 à la fois au plot 125 et au plot 129 de la carte de circuit imprimé 320, à savoir le plot de connexion 105 du transistor 300 dans cet exemple. L'inductance Lₛₚ₂ correspond quant à elle à l'inductance parasite de l'ensemble des éléments conducteurs reliant le plot de connexion 105 du transistor 300 à la borne A2, à savoir le plot de connexion 125 de la carte de circuit imprimé, et la ou les pistes conductrices reliant le plot 125 à la borne A2. L'inductance Lₛₛ correspond quant à elle à l'inductance parasite de l'ensemble des éléments conducteurs reliant le plot de connexion 105 du transistor 200 à la borne B2, à savoir le plot de connexion 129 de la carte de circuit imprimé, et la ou les pistes conductrices reliant le plot 129 à la borne A4 (ainsi qu'éventuellement la ou les pistes conductrices reliant la borne A4 à la borne B2, dont l'inductance parasite est considérée comme négligeable dans l'exemple représenté).

Un avantage du mode de réalisation décrit en relation avec les figures 3A, 3B et 3C est qu'il permet d'utiliser un transistor discret comportant un unique plot de connexion de source accessible à l'extérieur du boîtier du transistor, et, moyennant une simple modification du motif conducteur de la carte de circuit imprimé pour créer un plot de contrôle de source disjoint du plot de source de conduction, de réduire significativement l'inductance parasite de connexion de source vue à la fois par le circuit de contrôle du transistor et par le chemin de puissance du dispositif. Ceci permet, par rapport à la configuration des figures 1A, 1B et 1C, d'augmenter la vitesse de commutation du transistor sans augmenter les risques de dysfonctionnements (sans pour autant utiliser un composant muni d'un plot de contrôle supplémentaire comme dans l'exemple des figures 2A, 2B et 2C).

Des modes de réalisation particuliers ont été décrits. Diverses variantes et modifications apparaîtront à l'homme de l'art. En particulier, on a décrit ci-dessus des exemples de réalisation appliqués à des transistors HEMT au GaN ou à des transistors MOS. Les modes de réalisation ne se limitent toutefois pas à ces cas particuliers. Plus généralement, les modes de réalisation décrits peuvent être appliqués à tout transistor comportant deux bornes de conduction et une borne de commande destinée à recevoir un signal électrique de commande référencé par rapport à l'une des bornes de conduction, par exemple des transistors bipolaires ou des transistors à effet de champ. Les modes de réalisation décrits sont notamment particulièrement adaptés aux transistors à commutation rapide. Outre les exemples mentionnés ci-dessus, les modes de réalisation décrits sont notamment particulièrement avantageux pour des transistors MOS au carbure de silicium ou pour des transistors MOS à superjonction silicium.

De plus, les modes de réalisation décrits ne se limitent pas à l'application susmentionnée à des convertisseurs de puissance à découpage, mais peuvent s'appliquer plus généralement à tout dispositif électronique comportant un transistor discret monté sur une carte de circuit imprimé.

Par ailleurs, on a représenté, en figures 3A et 3B, un exemple de réalisation dans lequel un unique plot de contrôle de source 129 est prévu sur la carte de circuit imprimé. A titre de variante, plusieurs plots de contrôle de source disjoints, destinés à être connectés au même plot de connexion de source 105 du transistor que le plot de source de conduction 125, peuvent être prévus sur la carte de circuit imprimé. A titre d'exemple, deux plots de contrôle de source disjoints disposés de part et d'autre du plot de source de conduction 125 peuvent être prévus sur la carte de circuit imprimé. Les différents plots de contrôle de source de la carte de circuit imprimé peuvent être connectés à des circuits de contrôle distincts, ou à un même circuit de contrôle.

## Revendications

1. Dispositif électronique comportant :
un transistor discret (300) comportant une puce semiconductrice encapsulée dans un boîtier (101) en un matériau isolant laissant accessible un premier plot (105) de connexion à une première borne de conduction (S) du transistor, un deuxième plot (103) de connexion à une deuxième borne de conduction (D) du transistor, et un troisième plot (107) de connexion à une borne de commande (G) du transistor ; et
une carte de circuit imprimé (320) comportant des premier (125), deuxième (129), troisième (123) et quatrième (127) plots de connexion disjoints,
dans lequel :
- le transistor est monté sur la carte de circuit imprimé de façon que le premier plot de connexion (105) du transistor soit en contact avec les premier (125) et deuxième (129) plots de connexion de la carte de circuit imprimé et que les deuxième (103) et troisième (107) plots de connexion du transistor soient respectivement en contact avec les troisième (123) et quatrième (127) plots de connexion de la carte de circuit imprimé ;
**caractérisé en ce que**
- le dispositif comporte en outre, monté sur la carte de circuit imprimé (320), un circuit de contrôle (310) du transistor, connecté à la borne de commande (G) du transistor par l'intermédiaire du quatrième plot de connexion (127) de la carte de circuit imprimé et à la première borne de conduction (S) du transistor par l'intermédiaire du deuxième plot de connexion (129) de la carte de circuit imprimé ; et
- le premier plot de connexion (125) de la carte de circuit imprimé est connecté à une borne de conduction de puissance (A2) du dispositif.

2. Dispositif selon la revendication 1, dans lequel le circuit de contrôle (310) est configuré pour commuter alternativement le transistor (300) à l'état ouvert et à l'état fermé à une fréquence supérieure à 10 kHz.

3. Dispositif selon la revendication 1 ou 2, dans lequel, en vue de dessus, la distance entre le deuxième plot de connexion (129) de la carte de circuit imprimé et le quatrième plot de connexion (127) de la carte de circuit imprimé est inférieure au dixième de la plus grande dimension du transistor (300) .

4. Dispositif selon l'une quelconque des revendications 1 à 3, dans lequel :
la carte de circuit imprimé comprend en outre un cinquième plot de connexion disjoint des premier (125) et deuxième (129) plots de connexion de la carte de circuit imprimé ;
le transistor est monté sur la carte de circuit imprimé de façon que le premier plot de connexion (105) du transistor soit en contact avec les premier (125), deuxième (129) et cinquième plots de connexion de la carte de circuit imprimé ; et
le cinquième plot de connexion de la carte de circuit imprimé étant connecté au circuit de contrôle (310) ou à un circuit de contrôle supplémentaire du transistor.

5. Dispositif selon l'une quelconque des revendications 1 à 4, dans lequel les plots de connexion (103, 105, 107, 123, 125, 127, 129) sont en métal.

6. Dispositif selon l'une quelconque des revendications 1 à 5, dans lequel les plots de connexion (103, 105, 107, 123, 125, 127, 129) sont en cuivre.

7. Dispositif selon l'une quelconque des revendications 1 à 6, dans lequel le transistor (300) est un transistor MOS, la première borne de conduction (S) étant une borne de source du transistor.

8. Dispositif selon la revendication 7 dans son rattachement à la revendication 2, dans lequel la deuxième borne de conduction (D) et la borne de commande (G) sont respectivement une borne de drain et une borne de grille du transistor.

9. Dispositif selon l'une quelconque des revendications 1 à 8, dans lequel le transistor (300) est un transistor au nitrure de gallium, un transistor MOS au carbure de silicium, ou un transistor MOS à superjonction silicium.

10. Dispositif selon l'une quelconque des revendications 1 à 9, dans lequel les premier (125), deuxième (129) et quatrième (127) plots de connexion de la carte de circuit imprimé (320) sont séparés par une région isolante en forme de F.

## Patentansprüche

1. Eine elektronische Einrichtung, die Folgendes aufweist:
einen diskreten Transistor (300), der einen Halbleiterchip aufweist, der in einem Gehäuse (101) aus einem isolierenden Material eingekapselt ist, das den Zugang zu einer ersten Anschlussfläche (105) zur Verbindung mit einem ersten Leitungsanschluss (S) des Transistors, einer zweiten Anschlussfläche (103) zur Verbindung mit einem zweiten Leitungsanschluss (D) des Transistors und einer dritten Anschlussfläche (107) zur Verbindung mit einem Steueranschluss (G) des Transistors freigibt; und
eine gedruckte Leiterplatte (320), die erste (125), zweite (129), dritte (123) und vierte (127) separate Anschlussflächen aufweist,
wobei:
- der Transistor auf der Leiterplatte so montiert ist, dass die erste Anschlussfläche (105) des Transistors mit der ersten (125) und der zweiten (129) Anschlussfläche der Leiterplatte in Kontakt ist und die zweite (103) und die dritte (107) Anschlussfläche des Transistors mit der dritten (123) bzw. der vierten (127) Anschlussfläche der Leiterplatte in Kontakt sind; **dadurch gekennzeichnet, dass**
- die Einrichtung ferner eine auf der Leiterplatte (320) montierte Steuerschaltung (310) des Transistors aufweist, die über die vierte Anschlussfläche (127) der Leiterplatte mit dem Steueranschluss (G) des Transistors und über die zweite Anschlussfläche (129) der Leiterplatte mit dem ersten Leitungsanschluss (S) des Transistors verbunden ist; und
- die erste Anschlussfläche (125) der Leiterplatte mit einem Stromleitungsanschluss (A2) der Einrichtung verbunden ist.

2. Einrichtung nach Anspruch 1, wobei die Steuerschaltung (310) so konfiguriert ist, dass sie den Transistor (300) mit einer Frequenz von mehr als 10 kHz abwechselnd in den Aus-Zustand und in den Ein-Zustand schaltet.

3. Einrichtung nach Anspruch 1 oder 2, wobei in der Draufsicht der Abstand zwischen der zweiten Anschlussfläche (129) der Leiterplatte und der vierten Anschlussfläche (127) der Leiterplatte kürzer als ein Zehntel der größten Abmessungen des Transistors (300) ist.

4. Einrichtung nach einem der Ansprüche 1 bis 3, wobei:
die Leiterplatte außerdem eine fünfte Anschlussfläche aufweist, das von den ersten (125) und zweiten (129) Anschlussflächen der Leiterplatte getrennt ist;
der Transistor auf der Leiterplatte so montiert ist, dass die erste Anschlussfläche (105) des Transistors mit der ersten (125), zweiten (129) und fünften Anschlussfläche der Leiterplatte in Kontakt ist; und
wobei die fünfte Anschlussfläche der Leiterplatte mit der Steuerschaltung (310) oder mit einer zusätzlichen Steuerschaltung des Transistors verbunden ist.

5. Einrichtung nach einem der Ansprüche 1 bis 4, wobei die Anschlussflächen (103, 105, 107, 123, 125, 127, 129) aus Metall bestehen.

6. Einrichtung nach einem der Ansprüche 1 bis 5, wobei die Anschlussflächen (103, 105, 107, 123, 125, 127, 129) aus Kupfer bestehen.

7. Einrichtung nach einem der Ansprüche 1 bis 6, wobei der Transistor (300) ein MOS-Transistor ist und der erste Leitungsanschluss (S) ein Source-Anschluss des Transistors ist.

8. Einrichtung nach Anspruch 7 und Anspruch 2, wobei der zweite Leitungsanschluss (D) und der Steueranschluss (G) ein Drain-Anschluss bzw. ein Gate-Anschluss des Transistors sind.

9. Einrichtung nach einem der Ansprüche 1 bis 8, wobei der Transistor (300) ein Galliumnitridtransistor, ein Siliziumkarbid-MOS-Transistor oder ein Silizium-Superjunction-MOS-Transistor ist.

10. Einrichtung nach einem der Ansprüche 1 bis 9, wobei die erste (125), zweite (129) und vierte (127) Anschlussfläche der Leiterplatte (320) durch einen F-förmigen Isolierbereich getrennt sind.

## Claims

1. An electronic device comprising:
a discrete transistor (300) comprising a semiconductor chip encapsulated in a package (101) made of an insulating material leaving access to a first pad (105) of connection to a first conduction terminal (S) of the transistor, a second pad (103) of connection to a second conduction terminal (D) of the transistor, and a third pad (107) of connection to a control terminal (G) of the transistor ; and
a printed circuit board (320) comprising first (125), second (129), third (123) and fourth (127) separate connection pads,
wherein :
- the transistor is assembled on the printed circuit board so that the first connection pad (105) of the transistor is in contact with the first (125) and second (129) pads of connection of the printed circuit board and the second (103) and third (107) connection pads of the transistor are respectively in contact with the third (123) and fourth (127) connection pads of the printed circuit board ; **characterized in that**
- the device further comprises, assembled on the printed circuit board (320), a circuit of control (310) of the transistor, connected to the control terminal (G) of the transistor via the fourth connection pad (127) of the printed circuit board and to the first conduction terminal (S) of the transistor via the second connection pad (129) of the printed circuit board; and
- the first connection pad (125) of the printed circuit board is connected to a power conduction terminal (A2) of the device.

2. The device of claim 1, wherein the control circuit (310) is configured to alternately switch the transistor (300) to the off state and to the on state at a frequency greater than 10 kHz.

3. The device of claim 1 or 2, wherein, in top view, the distance between the second connection pad (129) of the printed circuit board and the fourth connection pad (127) of the printed circuit board is shorter than one tenth of the largest dimensions of the transistor (300).

4. The device of any of claims 1 to 3, wherein:
the printed circuit board further comprises a fifth connection pad separate from the first (125) and second (129) connection pads of the printed circuit board;
the transistor is assembled on the printed circuit board so that the first connection pad (105) of the transistor is in contact with the first (125), second (129), and fifth connection pads of the printed circuit board; and
the fifth connection pad of the printed circuit board being connected to the control circuit (310) or to a supplementary control circuit of the transistor.

5. The device of any of claims 1 to 4, wherein the connection pads (103, 105, 107, 123, 125, 127, 129) are made of metal.

6. The device of any of claims 1 to 5, wherein the connection pads (103, 105, 107, 123, 125, 127, 129) are made of copper.

7. The device of any of claims 1 to 6, wherein the transistor (300) is a MOS transistor, the first conduction terminal (S) being a source terminal of the transistor.

8. The device of claim 7 and of claim 2, wherein the second conduction terminal (D) and the control terminal (G) are respectively a drain terminal and a gate terminal of the transistor.

9. The device of any of claims 1 to 8, wherein the transistor (300) is a gallium nitride transistor, a silicon carbide MOS transistor, or a silicon superjunction MOS transistor.

10. The device of any of claims 1 to 9, wherein the first (125), second (129) and fourth (127) connection pads of the printed circuit board (320) are separated by an F shaped insulating region.
